# EUROPEAN PATENT APPLICATION

(11) **EP 4 836 216 A1**
(43) Date of publication of application: **04.11.2026**
(21) Application number: 24921829.8
(22) Date of filing: 31.12.2024
(51) Int. Cl.: H02H 7/122, H02H 1/00, H02H 3/32, G01R 31/52

(54) **INVERTER AND LEAKAGE CURRENT DETECTION DEVICE**

(30) Priority: 29.01.2024 CN 202410129770
(71) Applicant: Huawei Digital Power Technologies Co., Ltd., Shenzhen, Guangdong 518043 (CN)
(72) Inventor: WANG, Kun, Shenzhen, Guangdong 518043 (CN); ZHAO, Xing, Shenzhen, Guangdong 518043 (CN); FU, Mingxiao, Shenzhen, Guangdong 518043 (CN); ZHANG, Zhihong, Shenzhen, Guangdong 518043 (CN)
(74) Representative: Epping - Hermann - Fischer
(86) International application number: PCT/CN2024/144232
(87) International publication number: WO 2025/161807

(57) **Abstract**

This application discloses an inverter and a leakage current detection apparatus, and relates to the field of power supply detection technologies. The inverter in this application includes an inverter circuit and a leakage current detection apparatus. The leakage current detection apparatus includes a positive direct current source, a negative direct current source, a leakage current transformer, a self-excited oscillation circuit, a sampling resistor, and a controller. The self-excited oscillation circuit drives states of two switching transistors via one active comparator, so that the two switching transistors are switched back and forth between two states: an on state and an off state separately, to generate an excitation signal with a fixed frequency and an alternating waveform. In addition, the sampling resistor is connected in series to a first end of a detection winding of the leakage current transformer, so that a voltage in an internal magnetic field generated by the excitation signal is sampled at two ends of the sampling resistor. In this way, a leakage current on a power connection line is detected based on the voltage at the two ends of the sampling resistor, so that the leakage current detection apparatus can perform leakage current protection on the inverter, thereby improving safety of the inverter.

## Description

This application claims priority to Chinese Patent Application No. 202410129770.X, filed with the China National Intellectual Property Administration on January 29, 2024 and entitled "INVERTER AND LEAKAGE CURRENT DETECTION APPARATUS", which is incorporated herein by reference in its entirety.

### TECHNICAL FIELD

This application relates to the field of power supply detection technologies, and in particular, to an inverter and a leakage current detection apparatus.

### BACKGROUND

As electrical devices are popularized and used, safety of the electrical devices becomes increasingly important. A leakage current is one of common safety risks for the electrical devices, is usually caused by grounding faults, insulation damage, electrical aging, and the like, and may cause electrical accidents and threaten personal safety and device property. Therefore, a leakage current detection requirement is increasingly important.

A leakage current detection technology can effectively detect a leakage current problem in an electrical device, to detect and handle a safety risk in a timely manner. For example, in an industrial production process, leakage current detection needs to be performed on various electrical devices to ensure production safety and working efficiency. In the civil field, leakage current detection also needs to be performed on household appliances to protect safety of family members. In the medical field, leakage current detection also needs to be performed on various medical devices to ensure safety of a medical process.

### SUMMARY

According to a first aspect, this application provides an inverter, including an inverter circuit and a leakage current detection apparatus. The inverter circuit is configured to: convert a received direct current into an alternating current, and output the alternating current to a load. The leakage current detection apparatus includes a positive direct current source, a negative direct current source, a leakage current transformer, a self-excited oscillation circuit, a sampling resistor, and a controller.

The leakage current transformer may be an electrical element configured to detect a leakage current. The leakage current transformer includes a magnetic core and a detection winding wound around the magnetic core, and the magnetic core is sleeved on a power connection line.

The self-excited oscillation circuit is a circuit that can generate an excitation signal (for example, a square wave signal or a rectangular signal) with a fixed frequency and an alternating waveform. The self-excited oscillation circuit includes a comparator, a first resistor, a first voltage divider resistor, a second voltage divider resistor, a first switching transistor, and a second switching transistor.

A first power supply end of the comparator is separately connected to the positive direct current source and one end of the first resistor, the other end of the first resistor is connected to an output end of the comparator, and a second power supply end of the comparator is connected to the negative direct current source. A non-inverting input end of the comparator is connected to a first end of the detection winding. An inverting input end of the comparator is separately connected to one end of the first voltage divider resistor and one end of the second voltage divider resistor, the other end of the first voltage divider resistor is connected to a second end of the detection winding, and the other end of the second voltage divider resistor is grounded. The output end of the comparator is separately connected to a drive end of the first switching transistor and a drive end of the second switching transistor.

An input end of the first switching transistor is connected to the positive direct current source, and an output end of the second switching transistor is connected to the negative direct current source. An output end of the first switching transistor is separately connected to an input end of the second switching transistor and the second end of the detection winding.

One end of the sampling resistor is connected to the non-inverting input end of the comparator, and the other end of the sampling resistor is grounded.

The controller is configured to: when an integral value of a voltage value of a voltage at two ends of the sampling resistor in a single cycle is not 0, output a signal indicating that there is a leakage current on the power connection line.

It can be learned that the self-excited oscillation circuit in this application drives states of the two switching transistors (namely, the first switching transistor and the second switching transistor) via one active comparator, so that the two switching transistors are switched back and forth between two states: an on state and an off state separately, to load an excitation signal with a fixed frequency and an alternating waveform to the detection winding of the leakage current transformer, causing the magnetic core to be magnetized repetitively and saturated. In addition, the sampling resistor is connected in series to the first end of the detection winding, so that sampled signals at the two ends of the sampling resistor may be signals output by the detection winding under an internal magnetic field generated by the excitation signal.

If there is no leakage current on the power connection line, there is no external magnetic field generated by the leakage current in the magnetic core, so that a waveform of the sampled signal is symmetrical in a positive half cycle and a negative half cycle in an excitation cycle. If there is a leakage current on the power connection line, the leakage current generates an external magnetic field. When a direction of the external magnetic field is the same as a direction of the internal magnetic field, faster magnetic saturation of the magnetic core is improved. When a direction of the external magnetic field is opposite to a direction of the internal magnetic field, magnetic saturation of the magnetic core is delayed, so that a waveform of the sampled signal is asymmetrical in positive and negative directions in an excitation cycle. In this way, because the waveform of the sampled signal changes when there is no leakage current and when there is a leakage current, whether there is a leakage current on the power connection line is determined by detecting whether the integral value of the voltage value of the voltage at the two ends of the sampling resistor in the single cycle is 0. When the integral value of the voltage of the voltage value at the two ends of the sampling resistor in the single cycle is not 0, there is a leakage current on the power connection line. In this way, the leakage current detection apparatus can perform leakage current protection on the inverter, to improve safety of the inverter.

Optionally, if an input voltage of the non-inverting input end of the comparator is higher than an input voltage of the inverting input end of the comparator, a signal output by the comparator is at a high level. If an input voltage of the non-inverting input end of the comparator is lower than an input voltage of the inverting input end of the comparator, a signal output by the comparator is at a low level. If the signal output by the comparator is at a high level, the first switching transistor is in an off state and the second switching transistor is in an on state. If the signal output by the comparator is at a low level, the first switching transistor is in an on state and the second switching transistor is in an off state.

It can be learned that whether the signal output by the comparator is at a high level or a low level is determined based on a magnitude relationship between the input voltage of the non-inverting input end of the comparator and the input voltage of the inverting input end of the comparator. Then, the states of the first switching transistor and the second switching transistor are driven based on the signal output by the comparator, so that the two switching transistors are switched back and forth between the two states: the on state and the off state respectively; and the two switching transistors are not turned on together, to load an excitation signal with a fixed frequency and an alternating waveform to the detection winding of the leakage current transformer, causing the magnetic core to be magnetized repetitively and saturated.

Optionally, the self-excited oscillation circuit further includes a first current-limiting resistor and a second current-limiting resistor. The input end of the first switching transistor is connected to the positive direct current source via the first current-limiting resistor. The output end of the second switching transistor is connected to the negative direct current source via the second current-limiting resistor.

It can be learned that the first current-limiting resistor is used to limit a current flowing to the first switching transistor to ensure working performance of the first switching transistor, and the second current-limiting resistor is used to limit a current flowing to the second switching transistor to ensure working performance of the second switching transistor. Optionally, the self-excited oscillation circuit further includes a third current-limiting resistor and a fourth current-limiting resistor. The output end of the first switching transistor is connected to one end of the third current-limiting resistor, and the input end of the second switching transistor is connected to one end of the fourth current-limiting resistor. The other end of the third current-limiting resistor is separately connected to the other end of the fourth current-limiting resistor and the second end of the detection winding.

It can be learned that the third current-limiting resistor is used to limit a current flowing to the first switching transistor to ensure working performance of the first switching transistor, and the fourth current-limiting resistor is used to limit a current flowing to the second switching transistor to ensure working performance of the second switching transistor. Optionally, the self-excited oscillation circuit further includes a first diode and a second diode. A positive end of the first diode is separately connected to a negative end of the second diode and the second end of the detection winding, and a negative end of the first diode is connected to the positive direct current source. A positive end of the second diode is connected to the negative direct current source.

It can be learned that the first diode and the second diode can introduce an induced current into the positive direct current source VCC, to avoid damage caused by the induced current to a component in the self-excited oscillation circuit.

Optionally, the self-excited oscillation circuit further includes a second resistor. The output end of the comparator is connected to one end of the second resistor, and the other end of the second resistor is separately connected to the drive end of the first switching transistor and the drive end of the second switching transistor.

It can be learned that the second resistor is used to control a turn-on speed of the first switching transistor and a turn-on speed of the second switching transistor, to meet a required turn-on speed requirement.

Optionally, the self-excited oscillation circuit further includes a third resistor. The non-inverting input end of the comparator is connected to one end of the third resistor, and the other end of the third resistor is separately connected to the first end of the detection winding and the end of the sampling resistor.

It can be learned that the third resistor is used to limit a current flowing into the comparator, to protect the comparator. Optionally, the drive end of the first switching transistor is a gate of a PMOS transistor, the input end of the first switching transistor is a source of the PMOS transistor, and the output end of the first switching transistor is a drain of the PMOS transistor. The drive end of the second switching transistor is a gate of an N-channel metal-oxide-semiconductor NMOS transistor, the input end of the second switching transistor is a drain of the NMOS transistor, and the output end of the second switching transistor is a source of the NMOS transistor.

It can be learned that when the signal output by the comparator is at a high level, the PMOS transistor is in the off state and the NMOS transistor is in the on state; or when the signal output by the comparator is at a low level, the PMOS transistor is in the on state and the NMOS transistor is in the off state. In this way, states of the PMOS transistor and the NMOS transistor are driven based on the signal output by the comparator, so that the PMOS transistor and the NMOS transistor are switched back and forth between two states: an on state and an off state separately, to load an excitation signal with a fixed frequency and an alternating waveform to the detection winding of the leakage current transformer, causing the magnetic core to be magnetized repetitively and saturated.

Optionally, the inverter further includes a switch circuit. The switch circuit is disposed on the power connection line. The controller is further configured to: when a signal indicates that there is a leakage current on the power connection line, input a signal for controlling the switch circuit to be turned off.

It can be learned that, because the switch circuit is disposed on the power connection line, when a signal indicates that there is a leakage current on the power connection line, the switch circuit is turned off to avoid impact of the leakage current on a circuit on the power connection line.

According to a second aspect, this application provides a leakage current detection apparatus, including a positive direct current source, a negative direct current source, a leakage current transformer, a self-excited oscillation circuit, a sampling resistor, and a controller. The leakage current transformer includes a magnetic core and a detection winding wound around the magnetic core, and the magnetic core is sleeved on a power connection line. The self-excited oscillation circuit includes a comparator, a first resistor, a first voltage divider resistor, a second voltage divider resistor, a first switching transistor, and a second switching transistor.

A first power supply end of the comparator is separately connected to the positive direct current source and one end of the first resistor, the other end of the first resistor is connected to an output end of the comparator, and a second power supply end of the comparator is connected to the negative direct current source. A non-inverting input end of the comparator is connected to a first end of the detection winding. An inverting input end of the comparator is separately connected to one end of the first voltage divider resistor and one end of the second voltage divider resistor, the other end of the first voltage divider resistor is connected to a second end of the detection winding, and the other end of the second voltage divider resistor is grounded. The output end of the comparator is separately connected to a drive end of the first switching transistor and a drive end of the second switching transistor.

An input end of the first switching transistor is connected to the positive direct current source, and an output end of the second switching transistor is connected to the negative direct current source. An output end of the first switching transistor is separately connected to an input end of the second switching transistor and the second end of the detection winding. One end of the sampling resistor is connected to the non-inverting input end of the comparator, and the other end of the sampling resistor is grounded.

The controller is configured to: when an integral value of a voltage value of a voltage at two ends of the sampling resistor in a single cycle is not 0, output a signal indicating that there is a leakage current on the power connection line.

It can be learned that when there is no leakage current on the power connection line, a waveform of a sampled signal is symmetrical in a positive half cycle and a negative half cycle in an excitation cycle, so that the integral value of the voltage value of the voltage at the two ends of the sampling resistor in the single cycle is 0. When there is a leakage current on the power connection line, a waveform of a sampled signal is asymmetrical in positive and negative directions in an excitation cycle, and the integral value of the voltage value of the voltage at the two ends of the sampling resistor in the single cycle is not 0, that is, a voltage amplitude is not 0. In other words, compared with a case in which there is no leakage current, a voltage amplitude difference occurs when there is a leakage current.

In addition, there may be a mapping relationship between the voltage amplitude difference and a magnitude of the leakage current, and the mapping relationship may be obtained in advance through experimental measurement. In addition, a larger voltage amplitude difference indicates a larger magnitude of the leakage current; and a smaller voltage amplitude difference indicates a smaller magnitude of the leakage current. Finally, when a voltage amplitude difference is obtained, a magnitude of the leakage current can be determined based on the voltage amplitude difference and the mapping relationship.

Optionally, if an input voltage of the non-inverting input end of the comparator is higher than an input voltage of the inverting input end of the comparator, a signal output by the comparator is at a high level. If an input voltage of the non-inverting input end of the comparator is lower than an input voltage of the inverting input end of the comparator, a signal output by the comparator is at a low level. If the signal output by the comparator is at a high level, the first switching transistor is in an off state and the second switching transistor is in an on state. If the signal output by the comparator is at a low level, the first switching transistor is in an on state and the second switching transistor is in an off state.

It can be learned that whether the signal output by the comparator is at a high level or a low level is determined based on a magnitude relationship between the input voltage of the non-inverting input end of the comparator and the input voltage of the inverting input end of the comparator. Then, states of the first switching transistor and the second switching transistor are driven based on the signal output by the comparator, so that the two switching transistors are switched back and forth between the two states: the on state and the off state respectively; and the two switching transistors are not turned on together, to load an excitation signal with a fixed frequency and an alternating waveform to the detection winding of the leakage current transformer, causing the magnetic core to be magnetized repetitively and saturated.

Optionally, the self-excited oscillation circuit further includes a first current-limiting resistor and a second current-limiting resistor. The input end of the first switching transistor is connected to the positive direct current source via the first current-limiting resistor. The output end of the second switching transistor is connected to the negative direct current source via the second current-limiting resistor.

It can be learned that the first current-limiting resistor is used to limit a current flowing to the first switching transistor to ensure working performance of the first switching transistor, and the second current-limiting resistor is used to limit a current flowing to the second switching transistor to ensure working performance of the second switching transistor.

Optionally, the self-excited oscillation circuit further includes a third current-limiting resistor and a fourth current-limiting resistor. The output end of the first switching transistor is connected to one end of the third current-limiting resistor, and the input end of the second switching transistor is connected to one end of the fourth current-limiting resistor. The other end of the third current-limiting resistor is separately connected to the other end of the fourth current-limiting resistor and the second end of the detection winding.

It can be learned that the third current-limiting resistor is used to limit a current flowing to the first switching transistor to ensure working performance of the first switching transistor, and the fourth current-limiting resistor is used to limit a current flowing to the second switching transistor to ensure working performance of the second switching transistor. Optionally, the self-excited oscillation circuit further includes a first diode and a second diode. A positive end of the first diode is separately connected to a negative end of the second diode and the second end of the detection winding, and a negative end of the first diode is connected to the positive direct current source. A positive end of the second diode is connected to the negative direct current source.

It can be learned that the first diode and the second diode can introduce an induced current into the positive direct current source VCC, to avoid damage caused by the induced current to a component in the self-excited oscillation circuit.

Optionally, the self-excited oscillation circuit further includes a second resistor. The output end of the comparator is connected to one end of the second resistor, and the other end of the second resistor is separately connected to the drive end of the first switching transistor and the drive end of the second switching transistor.

It can be learned that the second resistor is used to control a turn-on speed of the first switching transistor and a turn-on speed of the second switching transistor, to meet a required turn-on speed requirement.

Optionally, the self-excited oscillation circuit further includes a third resistor. The non-inverting input end of the comparator is connected to one end of the third resistor, and the other end of the third resistor is separately connected to the first end of the detection winding and the end of the sampling resistor.

It can be learned that the third resistor is used to limit a current flowing into the comparator, to protect the comparator. Optionally, the drive end of the first switching transistor is a gate of a PMOS transistor, the input end of the first switching transistor is a source of the PMOS transistor, and the output end of the first switching transistor is a drain of the PMOS transistor. The drive end of the second switching transistor is a gate of an N-channel metal-oxide-semiconductor NMOS transistor, the input end of the second switching transistor is a drain of the NMOS transistor, and the output end of the second switching transistor is a source of the NMOS transistor.

It can be learned that when the signal output by the comparator is at a high level, the PMOS transistor is in the off state and the NMOS transistor is in the on state; or when the signal output by the comparator is at a low level, the PMOS transistor is in the on state and the NMOS transistor is in the off state. In this way, states of the PMOS transistor and the NMOS transistor are driven based on the signal output by the comparator, so that the PMOS transistor and the NMOS transistor are switched back and forth between two states: an on state and an off state separately, to load an excitation signal with a fixed frequency and an alternating waveform to the detection winding of the leakage current transformer, causing the magnetic core to be magnetized repetitively and saturated.

### BRIEF DESCRIPTION OF DRAWINGS

FIG. 1 is a diagram of an architecture of a photovoltaic energy storage system according to an embodiment of this application;
FIG. 2 is a diagram of a structure of a leakage current detection circuit according to an embodiment of this application;
FIG. 3 is an example diagram of a structure of a circuit loop of a leakage current detection circuit according to an embodiment of this application;
FIG. 4 is an example diagram of another structure of a circuit loop of a leakage current detection circuit according to an embodiment of this application;
FIG. 5 is an example diagram of a structure of a voltage waveform at a point B and a voltage waveform at two ends of a resistor R1 according to an embodiment of this application;
FIG. 6 is an example diagram of another structure of a voltage waveform at a point B and a voltage waveform at two ends of a resistor R1 according to an embodiment of this application;
FIG. 7 to FIG. 15 are diagrams of other structures of a leakage current detection circuit according to embodiments of this application;
FIG. 16 is a diagram of a structure of a leakage current detection apparatus according to an embodiment of this application;
FIG. 17 is a diagram of a structure of an inverter according to an embodiment of this application; and
FIG. 18 is a diagram of another structure of an inverter according to an embodiment of this application.

### DESCRIPTION OF EMBODIMENTS

To make a person skilled in the art understand technical solutions in this application better, the following clearly and completely describes the technical solutions in this application with reference to the accompanying drawings in this application. It is clear that the described embodiments are merely a part rather than all of embodiments of this application. All other embodiments obtained by a person skilled in the art based on descriptions of embodiments of this application without creative efforts shall fall within the protection scope of this application.

It should be understood that the terms such as "first" and "second" in this application are intended to distinguish between different objects but do not describe a specific sequence. In addition, the terms like "including" and "having" and any other variants thereof are intended to cover non-exclusive inclusion. For example, a process, a method, software, a product, or a device that includes a series of steps or units is not limited to the listed steps or units, but further includes an unlisted step or unit, or further includes another inherent step or unit of the process, the method, the product, or the device.

An "embodiment" in this application means that a particular feature, structure, or characteristic described with reference to the embodiment may be included in at least one embodiment of this application. The phrase shown in various locations in the specification may not necessarily refer to a same embodiment, and is not an independent or optional embodiment exclusive from another embodiment. In addition, embodiments described in this specification may be combined with another embodiment.

The term "and/or" in embodiments of this application may describe an association relationship between associated objects, and there may be three relationships. For example, A and/or B may represent the following three cases: "A", "B", and "A and B". A and B may be singular or plural.

The symbol "/" in embodiments of this application may represent an "or" relationship between associated objects. In addition, the symbol "/" may also represent a division sign, that is, perform a division operation. For example, A/B may represent that A is divided by B.

In embodiments of this application, "at least one item (piece) "or a similar expression thereof means any combination of these items, including a single item (piece) or any combination of plural items (pieces), and means one or more. "A plurality of" means two or more. For example, at least one of a, b, or c may represent the following seven cases: "a", "b", "c", "a and b", "a and c", "b and c", and "a, b, and c". Each of a, b, and c may be an element, or may be a set that includes one or more elements.

"Coupling" and "connection" in embodiments of this application may represent an electrical connection, and may include a direct connection through a wire or via a connection end or an indirect connection via another component (for example, an inductor, a capacitor, or a resistor). Therefore, "coupling" and "connection" may be considered as a generalized electronic communication connection. In addition, the displayed or discussed mutual couplings/direct couplings/connections may be implemented through some interfaces. Indirect couplings or connections between apparatuses, units, or devices may be implemented in communication, electrical, or other forms.

Circuits or other components in embodiments of this application may be described as "being configured to" perform one or more tasks. In this case, "being configured to" may be used for implying a structure by indicating that a circuit/component includes a structure (for example, a circuit system) that performs one or more tasks during an operation. Therefore, even when a specified circuit/component is currently not operable, the circuit/component may also be referred to as being configured to perform the task. Circuits/components used in conjunction with the "configured to" phrase include hardware, for example, a circuit for performing an operation.

A leakage current is one of common safety risks for electrical devices, is usually caused by grounding faults, insulation damage, electrical aging, and the like, and may cause electrical accidents and threaten personal safety and device property. Therefore, a leakage current detection requirement is increasingly important. In view of this, leakage current detection needs to be performed on electrical devices in embodiments. The electrical device may include a power supply device, a charging device, an uninterruptible power supply (Uninterruptible Power Supply, UPS), an inverter, or the like.

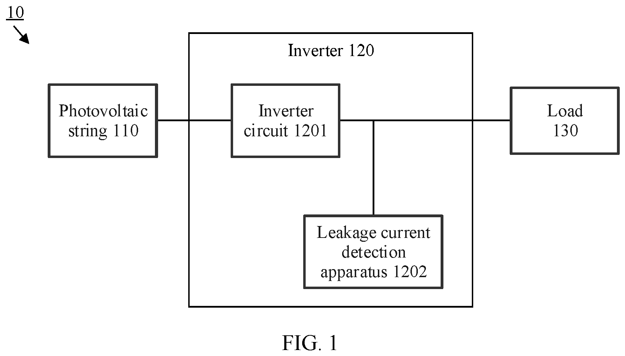

An inverter in a photovoltaic energy storage system is used as an example. As shown in FIG. 1, a photovoltaic energy storage system 10 includes a photovoltaic string 110, an inverter 120, and a load 130. The inverter 120 includes an inverter circuit 1201 and a leakage current detection apparatus 1202. The photovoltaic string 110 is a circuit unit formed by connecting several photovoltaic modules (usually photovoltaic cells of a same specification) in series in the photovoltaic energy storage system. The inverter circuit 1201 is a circuit that converts a direct current into an alternating current by controlling a switching transistor (for example, a transistor or a switching transistor), and outputs the alternating current to the load 130. The leakage current detection apparatus 1202 is an apparatus for detecting a leakage current. The load 130 may include various power-consuming devices, an alternating current grid, or the like. In this way, the leakage current detection apparatus 1202 performs leakage current protection on the inverter 120, to improve safety of the inverter 120.

The following specifically describes a leakage current detection circuit, a leakage current detection apparatus, and an electrical device in which the leakage current detection circuit is located.

### [Solution 1]

In "Solution 1", a circuit topology and a working principle of the leakage current detection circuit are specifically described in this embodiment. During specific implementation, the leakage current detection circuit may include a leakage current transformer, a self-excited oscillation circuit, and a sampling resistor.

The leakage current transformer may be an electrical element configured to detect a leakage current. The leakage current transformer may usually include a primary winding, a secondary winding, and a magnetic core. The primary winding may include a power connection line of an electrical device, one end of the secondary winding is connected to the self-excited oscillation circuit, and the magnetic core may be configured to induce a magnetic field generated by a leakage current of the electrical device. The secondary winding may also be referred to as a detection winding. The self-excited oscillation circuit is a circuit that can generate an excitation signal (for example, a square wave signal or a rectangular signal) with a fixed frequency and an alternating waveform. When the excitation signal flows through the secondary winding, the excitation signal generates an internal magnetic field, and the magnetic core is repetitively magnetized in the magnetic field and gradually reaches magnetic saturation.

The sampling resistor is a passive element in the leakage current detection circuit, and is configured to sample and measure physical quantities such as a current and a voltage. A resistance value of the sampling resistor may range from several ohms to hundreds of ohms. In the leakage current detection circuit, the sampling resistor may be connected in series to the other end of the secondary winding. In addition, sampled signals at the two ends of the sampling resistor may be signals output by the secondary winding under the internal magnetic field generated by the excitation signal.

If there is no leakage current on the power connection line, there is no external magnetic field generated by the leakage current in the magnetic core. In this case, a waveform of the sampled signal is symmetrical in a positive half cycle and a negative half cycle in an excitation cycle.

If there is a leakage current on the power connection line, the leakage current generates an external magnetic field. When a direction of the external magnetic field is the same as a direction of the internal magnetic field, faster magnetic saturation of the magnetic core is improved. When a direction of the external magnetic field is opposite to a direction of the internal magnetic field, magnetic saturation of the magnetic core is delayed. In this way, a waveform of the sampled signal is asymmetrical in positive and negative directions in an excitation cycle. It can be learned that, because the waveform of the sampled signal changes when there is no leakage current and when there is a leakage current, the sampled signal may be used to detect the leakage current on the power connection line.

"Circuit topology of the leakage current detection circuit"

The following describes the circuit topology of leakage current detection in this embodiment by using an example.

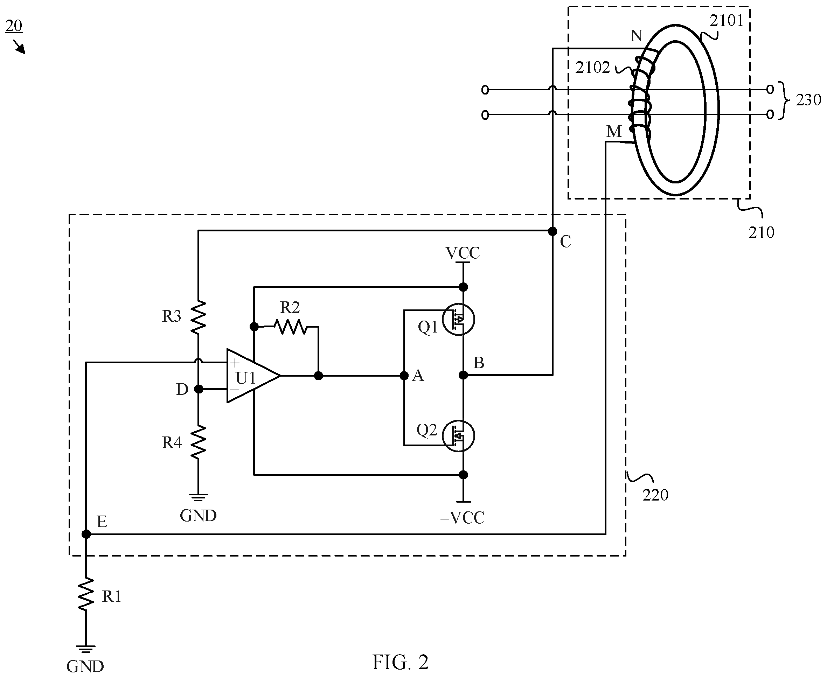

FIG. 2 is a diagram of a structure of a leakage current detection circuit according to an embodiment of this application. In FIG. 2, a leakage current detection circuit 20 includes a leakage current transformer 210, a self-excited oscillation circuit 220, and a resistor R1. The resistor R1 is used as a sampling resistor to detect a leakage current.

The leakage current transformer 210 includes a magnetic core 2101 and a detection winding 2102 wound around the magnetic core 2101, and the magnetic core 2101 is sleeved on a power connection line 230. A first end of the detection winding 2102 is represented by a point M, and a second end of the detection winding 2102 is represented by a point N.

The self-excited oscillation circuit 220 includes a comparator U1, a resistor R2, a resistor R3, a resistor R4, a switching transistor Q1, and a switching transistor Q2.

A first power supply end of the comparator U1 is separately connected to a positive direct current source VCC and one end of the resistor R2, the other end of the resistor R2 is connected to an output end of the comparator U1, and a second power supply end of the comparator U1 is connected to a negative direct current source -VCC.

A non-inverting input end of the comparator U1 is connected to the first end of the detection winding 2102. An inverting input end of the comparator U1 is separately connected to one end of the resistor R3 and one end of the resistor R4, the other end of the resistor R3 is connected to the second end of the detection winding 2102, and the other end of the resistor R4 is grounded GND. The output end of the comparator U1 is separately connected to a drive end of the switching transistor Q1 and a drive end of the switching transistor Q2.

An input end of the switching transistor Q1 is connected to the positive direct current source VCC, and an output end of the switching transistor Q2 is connected to the negative direct current source -VCC. An output end of the switching transistor Q1 is separately connected to an input end of the switching transistor Q2 and the second end of the detection winding 2102.

One end of the resistor R1 is connected to the non-inverting input end of the comparator U1, and the other end of the resistor R1 is grounded GND.

It should be noted that, if an input voltage (namely, a voltage at a point E) of the non-inverting input end of the comparator U1 is higher than an input voltage (namely, a voltage at a point D) of the inverting input end of the comparator U1, a signal output by the comparator U1 is at a high level. If an input voltage of the non-inverting input end of the comparator U1 is lower than an input voltage of the inverting input end of the comparator U1, a signal output by the comparator U1 is at a low level. If the signal output by the comparator U1 is at a high level, the switching transistor Q1 is in an off state and the switching transistor Q2 is in an on state; or if the signal output by the comparator U1 is at a low level, the switching transistor Q1 is in an on state and the switching transistor Q2 is in an off state. In addition, the switching transistor Q1 and the switching transistor Q2 may be triodes, metal-oxide-semiconductor field-effect transistors (metal-oxide-semiconductor field-effect transistor, MOSFET), insulated gate bipolar transistors (insulated gate bipolar transistor, IGBT), or the like. This is not specifically limited.

For example, the switching transistor Q1 and the switching transistor Q2 are MOSFETs. The switching transistor Q1 may be a P-channel metal-oxide-semiconductor (P-channel Metal-Oxide-Semiconductor, PMOS) transistor, and the switching transistor Q2 may be an N-channel metal-oxide-semiconductor (N-channel Metal-Oxide-Semiconductor, NMOS) transistor. The drive end of the switching transistor Q1 is a gate of the PMOS, the input end of the switching transistor Q1 is a source of the PMOS, and the output end of the switching transistor Q1 is a drain of the PMOS. The drive end of the switching transistor Q2 is a gate of the NMOS, the output end of the switching transistor Q2 is a source of the NMOS, and the input end of the switching transistor Q2 is a drain of the NMOS. In this way, the gate of the PMOS is connected to the output end of the comparator U1, the source of the PMOS is connected to the positive direct current source VCC, and the drain of the PMOS is separately connected to the drain of the NMOS and the second end of the detection winding 2102; and the gate of the NMOS is connected to the output end of the comparator U1, and the source of the NMOS is connected to the negative direct current source -VCC.

The following separately describes, by using examples, working principles of the leakage current detection circuit 20 with no leakage current on the power connection line 230 and with a leakage current on the power connection line 230.

"Working principle of the leakage current detection circuit without a leakage current"

When there is no leakage current on the power connection line 230, the working principle of the leakage current detection circuit 20 is as follows:
After the leakage current detection circuit 20 is powered on, the positive direct current source VCC provides a positive direct current for the first power supply end of the comparator U1 and the input end of the switching transistor Q1, and the negative direct current source -VCC provides a negative direct current for the second power supply end of the comparator U1 and the output end of the switching transistor Q2. In this case, the positive direct current source VCC generates a high level at a point A via the resistor R2.

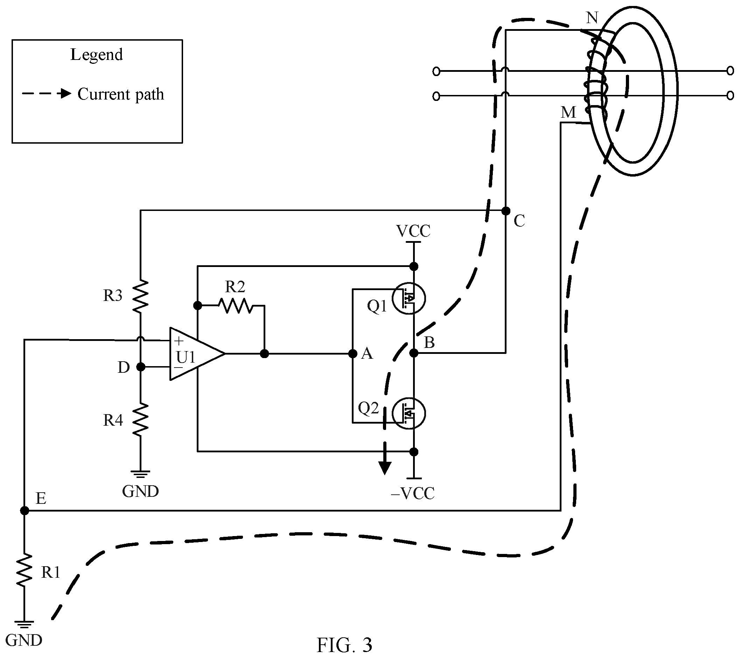

When the high level is generated at the point A, the switching transistor Q1 is in the off state and the switching transistor Q2 is in the on state. In this case, the leakage current detection circuit 20 generates a circuit loop, and a voltage at a point B and a voltage at a point C are pulled to -VCC, as shown in FIG. 3.

In FIG. 3, a current sequentially passes through the resistor R1, the first end of the detection winding 2102, the second end of the detection winding 2102, and the switching transistor Q2 from the GND, and finally flows to the negative direct current source -VCC. A current flowing through the detection winding 2102 generates an internal magnetic field, and the magnetic core 2101 is gradually magnetized in the magnetic field. As the magnetic core 2101 is magnetized, the voltage at the point E continuously moves toward -VCC from 0.

On a path from the point C to the resistor R4 that is grounded, the resistor R3 and the resistor R4 divide the voltage (-VCC) at the point C. For ease of differentiation and description, the resistor R3 may be referred to as a "first voltage divider resistor", and the resistor R4 may be referred to as a "second voltage divider resistor". In this case, the voltage at the point D is -VCC*R4/(R3+R4). A resistance value of the resistor R3 may be the same as or different from a resistance value of the resistor R4. When the resistance value of the resistor R3 is the same as the resistance value of the resistor R4, the voltage at the point D is -VCC/2.

The following uses an example in which the resistance value of the resistor R3 is the same as the resistance value of the resistor R4, and the voltage at the point D is -VCC/2 for description.

For the comparator U1, the input voltage of the inverting input end of the comparator U1 is the voltage at the point D, and the input voltage of the non-inverting input end of the comparator U1 is the voltage at the point E (namely, a voltage at the two ends of the resistor R1).

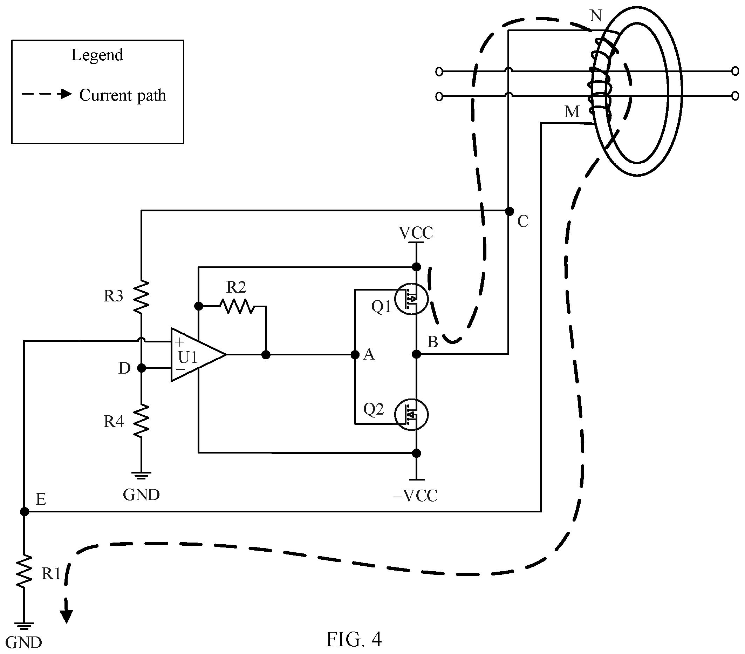

Because the voltage at the point E continuously moves toward -VCC from 0, when the voltage at the point E reaches -VCC/2 and continues to move toward -VCC, the voltage at the point E is lower than the voltage at the point D, that is, the input voltage of the non-inverting input end of the comparator U1 is lower than the input voltage of the inverting input end of the comparator U1. As a result, the signal output by the comparator U1 is at a low level. In this way, the point A changes from a high level to a low level. As a result, the switching transistor Q2 changes from the on state to the off state, and the switching transistor Q1 changes from the off state to the on state. In this case, the leakage current detection circuit 20 generates a new circuit loop, and the voltage at the point B and the voltage at the point C are pulled to VCC, as shown in FIG. 4.

In FIG. 4, a current sequentially passes through the switching transistor Q1, the second end of the detection winding 2102, the first end of the detection winding 2102, and the resistor R1 from the positive direct current source VCC, and finally flows to the ground GND. A current flowing through the detection winding 2102 generates an internal magnetic field, and the magnetic core 2101 is gradually magnetized in the magnetic field. As the magnetic core 2101 is magnetized, the voltage at the point E continuously moves toward VCC from -VCC/2 (or slightly lower than -VCC/2). On the path from the point C to the resistor R4 that is grounded, the resistor R3 and the resistor R4 divide the voltage (VCC) at the point C. Because it is assumed that the resistance value of the resistor R3 is the same as the resistance value of the resistor R4, the voltage at the point D is VCC/2.

Because the voltage at the point E continuously moves toward VCC from -VCC/2 (or slightly lower than -VCC/2), when the voltage at the point E reaches VCC/2 and continues to move toward VCC, the voltage at the point E is higher than the voltage at the point D, that is, the input voltage of the non-inverting input end of the comparator U1 is higher than the input voltage of the inverting input end of the comparator U1. As a result, the signal output by the comparator U1 is at a high level. In this way, the point A changes from a low level to a high level. As a result, the switching transistor Q2 changes from the off state to the on state, and the switching transistor Q1 changes from the on state to the off state. In this case, the leakage current detection circuit 20 further generates the circuit loop shown in FIG. 3. A current flowing through the detection winding 2102 generates an internal magnetic field, and the magnetic core 2101 is gradually magnetized in the magnetic field. As the magnetic core 2101 is magnetized, the voltage at the point E continuously moves toward -VCC from VCC/2 (or slightly higher than VCC/2).

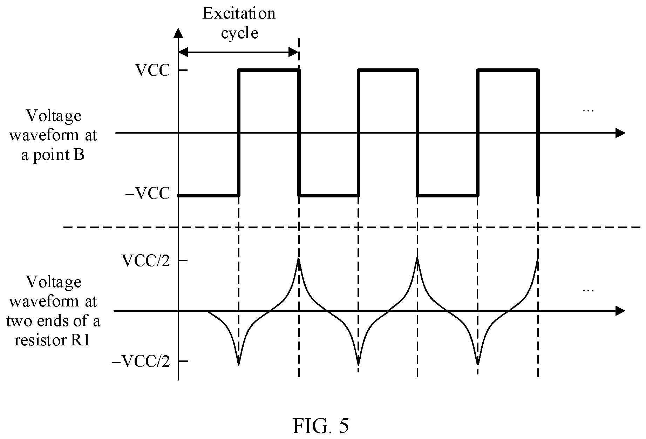

It can be learned that, the foregoing process is continuously repeated, so that a voltage waveform of the self-excited oscillation circuit 220 at the point B (or the point C) and a voltage waveform at the two ends of the resistor R1 (namely, a voltage waveform at the point E) are shown in FIG. 5. In FIG. 5, the voltage waveform at the point B is symmetrical in a positive half cycle and a negative half cycle in an excitation cycle, and the voltage waveform at the two ends of the resistor R1 is also symmetrical in the positive half cycle and the negative half cycle in the excitation cycle.

"Working principle of the leakage current detection circuit with a leakage current"

When there is a leakage current on the power connection line 230, the working principle of the leakage current detection circuit 20 is as follows:
The leakage current on the power connection line 230 generates an external magnetic field. When the leakage current detection circuit 20 generates a circuit loop shown in FIG. 3, a current flows to the second end of the detection winding 2102 from the first end of the detection winding 2102, a current flowing through the detection winding 2102 generates an internal magnetic field, and the magnetic core 2101 is gradually magnetized in the magnetic field. As the magnetic core 2101 is magnetized, the voltage at the point E continuously moves toward -VCC from 0.

In this case, when a direction of the external magnetic field generated by the leakage current on the power connection line 230 is the same as a direction of the internal magnetic field, faster magnetic saturation of the magnetic core 2101 is achieved, so that the voltage at the point E moves toward -VCC faster, that is, the voltage at the point E decreases faster.

When the voltage at the point E quickly reaches about -VCC/2, because the voltage at the point E is lower than the voltage at the point D, the signal output by the comparator U1 is at a low level. In this case, the leakage current detection circuit 20 generates a circuit loop shown in FIG. 4, and a current flows to the first end of the detection winding 2102 from the second end of the detection winding 2102. Because a direction of a current flowing through the detection winding 2102 in FIG. 4 is opposite to a direction of the current flowing through the detection winding 2102 in FIG. 3, a direction of an internal magnetic field generated by the current in FIG. 4 is opposite to a direction of the internal magnetic field generated by the current in FIG. 4. When the direction of the external magnetic field generated by the leakage current remains unchanged, because the direction of the external magnetic field generated by the leakage current is opposite to the direction of the internal magnetic field in this case, magnetic saturation of the magnetic core is delayed.

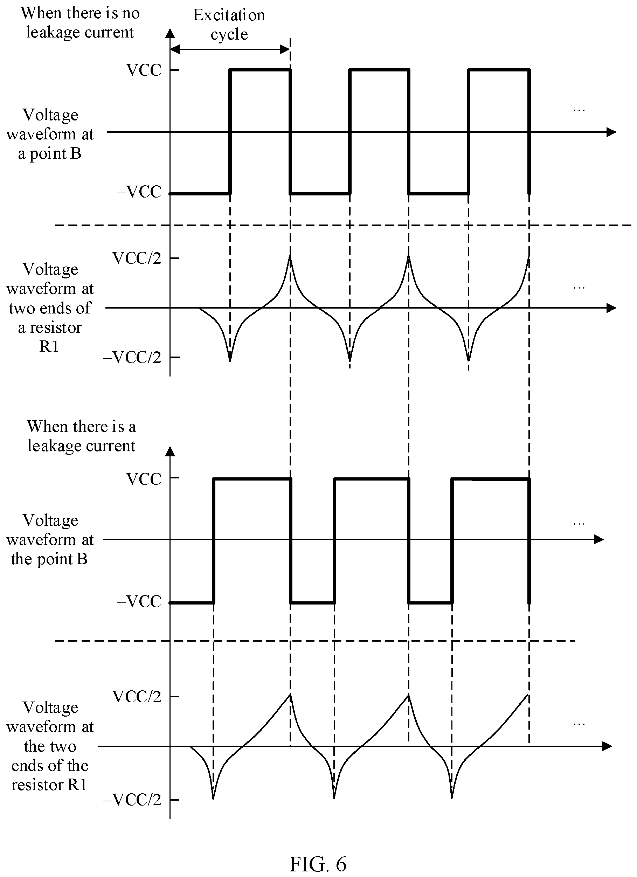

It can be learned that, the foregoing process is continuously repeated, so that a voltage waveform of the self-excited oscillation circuit 220 at a point B (or a point C) and a voltage waveform at two ends of the resistor R1 (namely, a voltage waveform at the point E) are shown in FIG. 6. In FIG. 6, the voltage waveform at the point B with no leakage current is symmetrical in a positive half cycle and a negative half cycle in an excitation cycle, and the voltage waveform at the point B with a leakage current is asymmetrical in positive and negative directions in the excitation cycle. In addition, the voltage waveform at the two ends of the resistor R1 with no leakage current is also symmetrical in a positive half cycle and a negative half cycle in an excitation cycle, and the voltage waveform at the two ends of the resistor R1 with a leakage current is asymmetrical in positive and negative directions in the excitation cycle. In this way, signals at the two ends of the resistor R1 can be used to detect a leakage current on the power connection line 230.

### [Solution 2]

For the leakage current detection circuit in "Solution 1", some additional components may be added in this embodiment to improve working performance of the leakage current detection circuit. In "Solution 2", in this embodiment, a current-limiting resistor may be added on a path from the positive direct current source VCC to the point B through the switching transistor Q1, to limit a current flowing to the switching transistor Q1, so as to ensure working performance of the switching transistor Q1; and/or a current-limiting resistor is added on a path from the negative direct current source -VCC to the point B through the switching transistor Q2, to limit a current flowing to the switching transistor Q2, so as to ensure working performance of the switching transistor Q2.

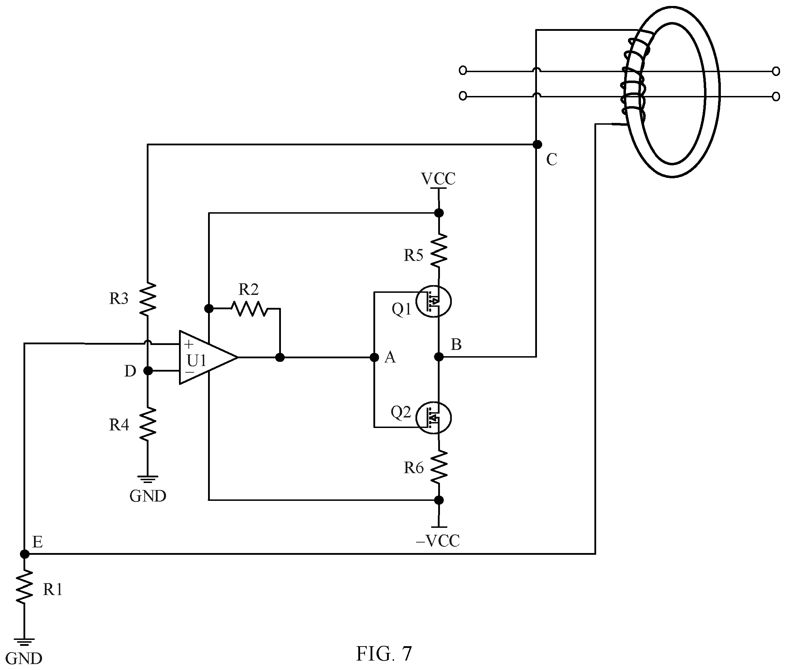

For example, a current-limiting resistor is added between the input end of the switching transistor Q1 and the positive direct current source VCC and between the output end of the switching transistor Q2 and the negative direct current source -VCC, as shown in FIG. 7. In FIG. 7, the self-excited oscillation circuit 220 further includes a resistor R5 and a resistor R6. The input end of the switching transistor Q1 is connected to one end of the resistor R5, and the other end of the resistor R5 is connected to the positive direct current source VCC, that is, the input end of the switching transistor Q1 is connected to the positive direct current source VCC via the resistor R5. The output end of the switching transistor Q2 is connected to one end of the resistor R6, and the other end of the resistor R6 is connected to the negative direct current source -VCC, that is, the output end of the switching transistor Q2 is connected to the negative direct current source -VCC via the resistor R6. For ease of differentiation and description, the resistor R5 may be referred to as a "first current-limiting resistor", and the resistor R6 may be referred to as a "second current-limiting resistor". In this way, the resistor R5 is used to limit the current flowing to the switching transistor Q1 to ensure working performance of the switching transistor Q1, and the resistor R6 is used to limit the current flowing to the switching transistor Q2 to ensure working performance of the switching transistor Q2.

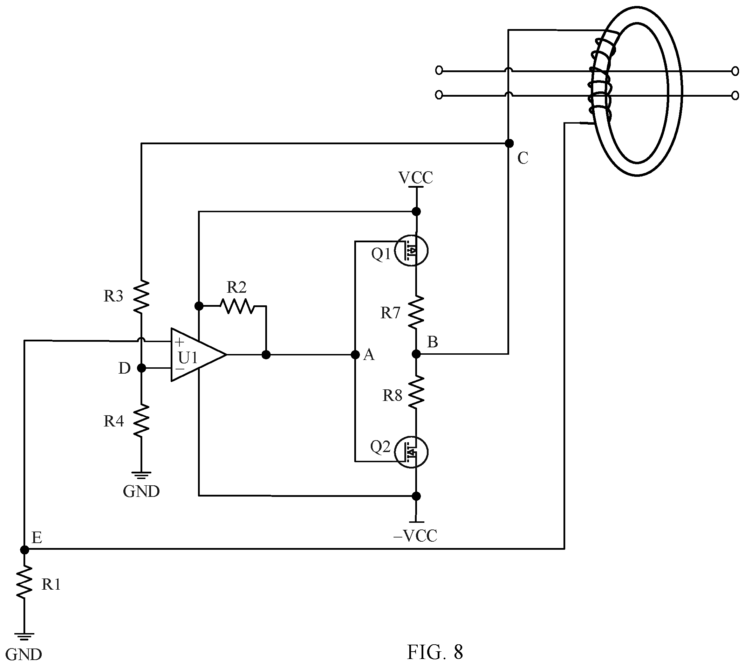

For another example, a current-limiting resistor is added between the output end of the switching transistor Q1 and the point B and between the input end of the switching transistor Q1 and the point B, as shown in FIG. 8. In FIG. 8, the self-excited oscillation circuit 220 further includes a resistor R7 and a resistor R8. The output end of the switching transistor Q1 is connected to one end of the resistor R7, and the input end of the switching transistor Q2 is connected to one end of the resistor R8. The other end of the resistor R7 is separately connected to the other end of the resistor R8 and the second end of the detection winding 2102. For ease of differentiation and description, the resistor R7 may be referred to as a "third current-limiting resistor", and the resistor R8 may be referred to as a "fourth current-limiting resistor".

In this way, the resistor R7 is used to limit the current flowing to the switching transistor Q1 to ensure working performance of the switching transistor Q1, and the resistor R8 is used to limit the current flowing to the switching transistor Q2 to ensure working performance of the switching transistor Q2.

### [Solution 3]

For the leakage current detection circuit in "Solution 1" or "Solution 2", some additional components may be added in this embodiment to protect a component in the leakage current detection circuit. The detection winding 2102 of the leakage current transformer 210 may be subject to an external magnetic field to generate an induced current, and the induced current flows to the self-excited oscillation circuit 220 along with the detection winding 2102. However, a high induced current may damage a component in the self-excited oscillation circuit 220. Therefore, damage caused by the high induced current needs to be considered.

For example, in a case of external lightning or the like, the detection winding 2102 is subject to an external magnetic field to generate a high induced current.

In view of this, in this embodiment, a diode may be connected to the second end of the detection winding 2102, so that the induced current is introduced into the positive direct current source VCC via the diode, thereby avoiding damage caused by the induced current to the component in the self-excited oscillation circuit 220.

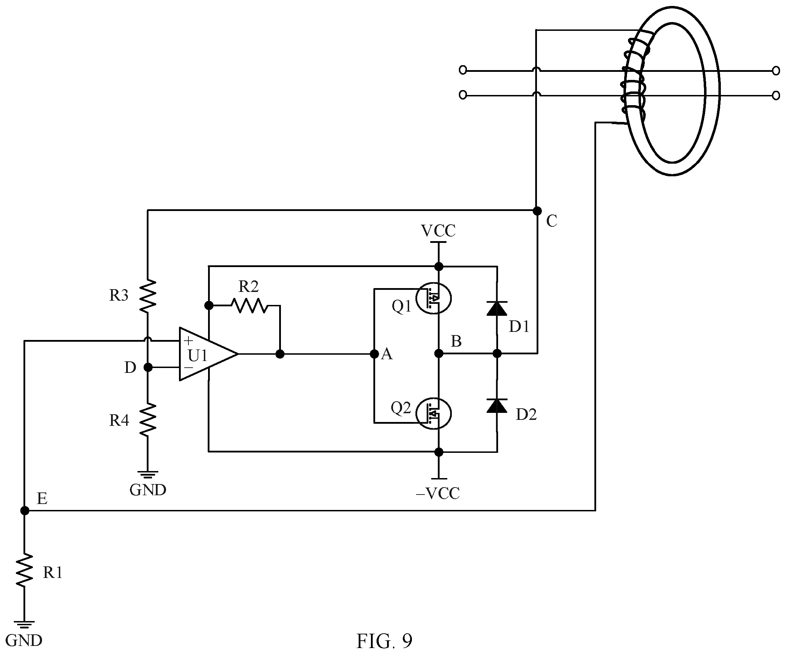

For example, as shown in FIG. 9, in FIG. 9, the self-excited oscillation circuit 220 further includes a diode D1 and a diode D2. A positive end of the diode D1 is separately connected to a negative end of the diode D2 and the second end of the detection winding 2102, a negative end of the diode D1 is connected to the positive direct current source VCC, and a positive end of the diode D2 is connected to the negative direct current source -VCC. For ease of differentiation and description, the diode D1 may be referred to as a "first diode", and the diode D2 may be referred to as a "second diode".

In this way, the diode D1 and the diode D2 can introduce an induced current into the positive direct current source VCC, to avoid the damage caused by the induced current to the component in the self-excited oscillation circuit 220.

### [Solution 4]

For the leakage current detection circuit in "Solution 1", "Solution 2", or "Solution 3", some additional components may be added in this embodiment to improve working performance of the leakage current detection circuit. In "Solution 4", in this embodiment, a resistor may be added on a path from the output end of the comparator U1 to the point A, and the resistor may be configured to control a turn-on speed of the switching transistor Q1 and a turn-on speed of the switching transistor Q2. In this way, a resistance value of the resistor is adjusted to ensure that the turn-on speed of the switching transistor Q1 or the switch Q2 is within a required range.

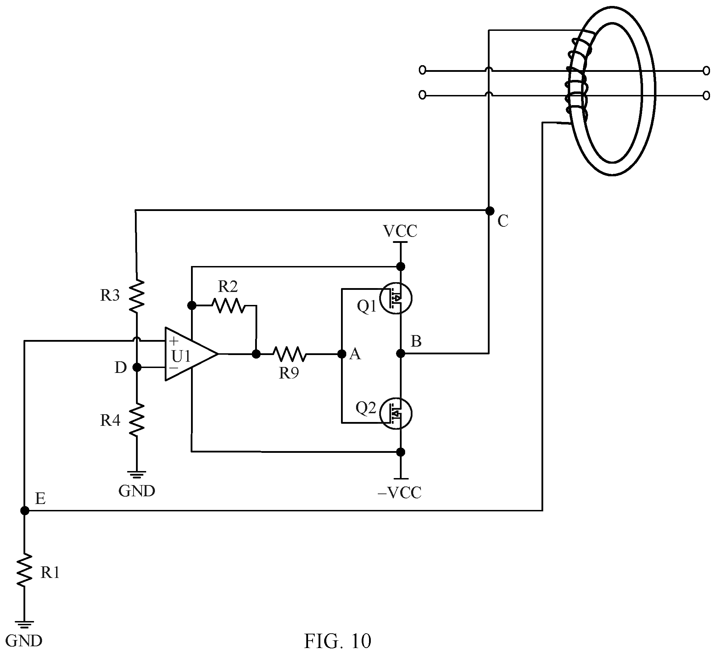

For example, as shown in FIG. 10, in FIG. 10, the self-excited oscillation circuit 220 further includes a resistor R9. The output end of the comparator U1 is connected to one end of the resistor R9, and the other end of the resistor R9 is separately connected to the drive end of the switching transistor Q1 and the drive end Q2 of the switching transistor. For ease of differentiation and description, the resistor R9 may be referred to as a "second resistor".

In this way, the resistor R9 controls the turn-on speed of the switching transistor Q1 and the turn-on speed of the switching transistor Q2, to meet a required turn-on speed requirement.

### [Solution 5]

For the leakage current detection circuit in "Solution 1", "Solution 2", "Solution 3", or "Solution 4", some additional components may be added in this embodiment to improve working performance of the leakage current detection circuit. In "Solution 5", in this embodiment, a resistor may be added on a path from the non-inverting input end of the comparator U1 to the point E, and the resistor may be configured to limit a current flowing into the comparator U1, to protect the comparator U1.

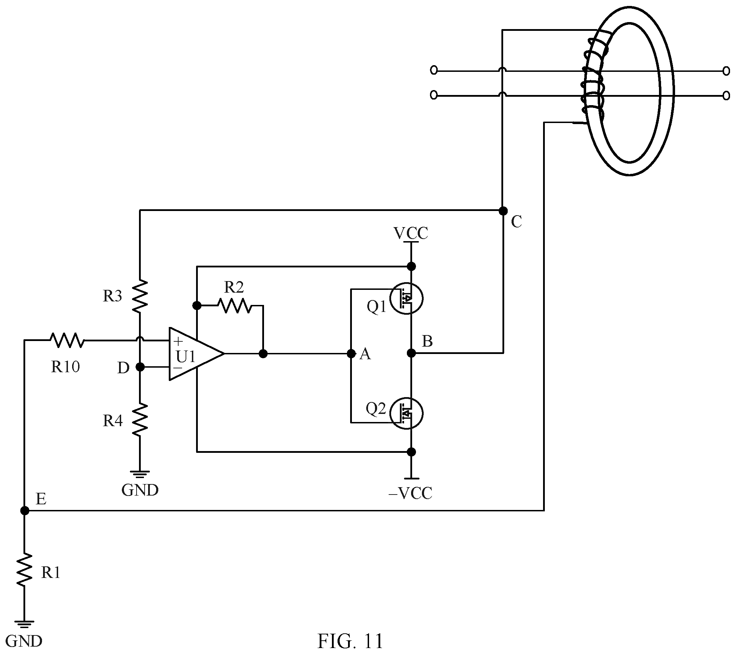

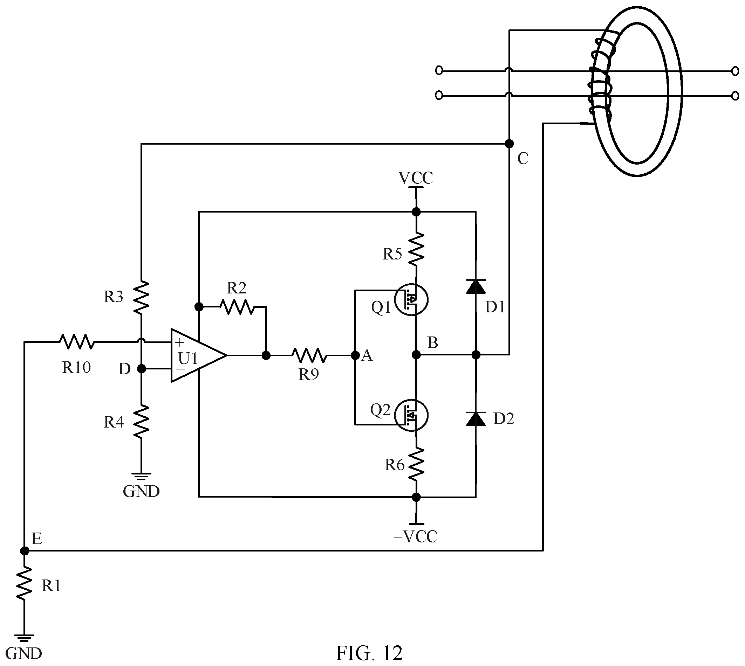

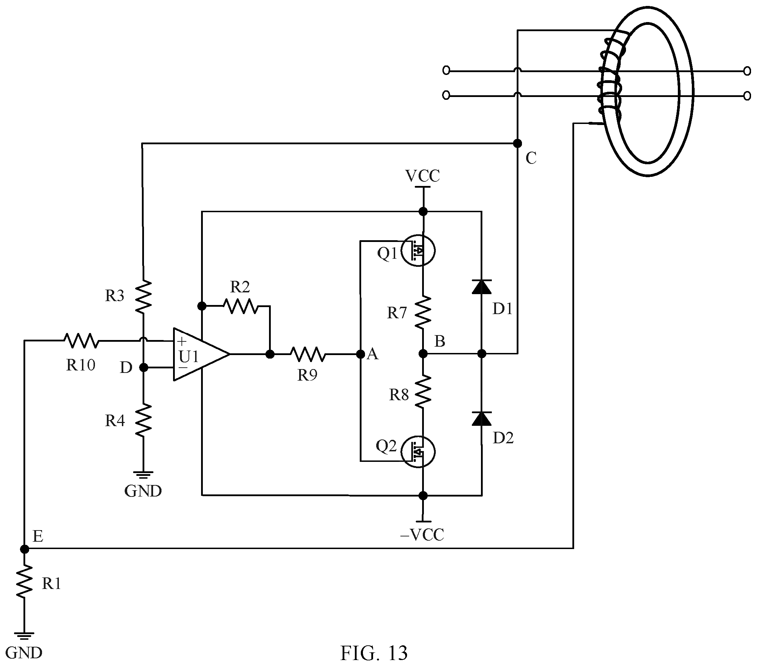

For example, as shown in FIG. 11, in FIG. 11, the self-excited oscillation circuit 220 further includes a resistor R10. The non-inverting input end of the comparator U1 is connected to one end of the resistor R10, and the other end of the resistor R10 is separately connected to the first end of the detection winding 2102 and the end of the resistor R1. In this way, the resistor R10 is used to limit the current flowing into the comparator U1, to protect the comparator U1. It should be noted that, in this embodiment, "Solution 1" may be combined with "Solution 2" to "Solution 5", to obtain a circuit topology of the leakage current detection circuit, so as to improve working performance of the leakage current detection circuit. For example, as shown in FIG. 12 and FIG. 13, details are not described herein again.

### [Solution 6]

The self-excited oscillation circuit 220 in this embodiment needs to separately drive states of the switching transistor Q1 and the switching transistor Q2, to generate an excitation signal. In the foregoing solution, in this embodiment, the states of the switching transistor Q1 and the switching transistor Q2 are directly driven based on a signal output by the comparator U1. For example, if the signal output by the comparator U1 is at a high level, the switching transistor Q1 is in an off state and the switching transistor Q2 is in an on state; or if the signal output by the comparator U1 is at a low level, the switching transistor Q1 is in an on state and the switching transistor Q2 is in an off state.

However, in "Solution 6", in this embodiment, a phase inverter may be added on a path from the output end of the comparator U1 to the point A, and the states of the switching transistor Q1 and the switching transistor Q2 are driven based on an output signal of the phase inverter. The phase inverter may convert an input high level into a low level or convert an input low level into a high level.

In this way, if the signal output by the comparator U1 is at a high level, the phase inverter outputs a low level, so that the switching transistor Q1 is in the off state and the switching transistor Q2 is in the on state; or if the signal output by the comparator U1 is at a low level, the phase inverter outputs a high level, so that the switching transistor Q1 is in the on state and the switching transistor Q2 is in the off state. For example, the switching transistor Q1 and the switching transistor Q2 are MOSFETs. In this case, the switching transistor Q1 may be an NMOS transistor, and the switching transistor Q2 may be a PMOS transistor.

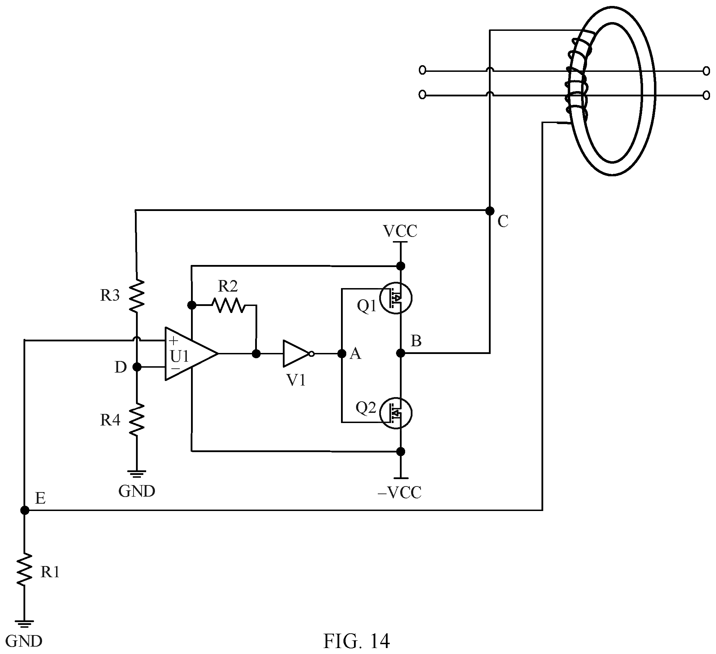

For example, a phase inverter is added to the leakage current detection circuit 20 shown in FIG. 2, as shown in FIG. 14. In FIG. 14, the self-excited oscillation circuit further includes a phase inverter V1. The output end of the comparator U1 is connected to an input end of the phase inverter V1, and the output end of the phase inverter V1 is separately connected to the drive end of the switching transistor Q1 and the drive end of the switching transistor Q2.

### [Solution 7]

In "Solution 7", the circuit topology of the leakage current detection apparatus is specifically described in this embodiment. During specific implementation, the leakage current detection apparatus may include a positive direct current source, a negative direct current source, a leakage current detection circuit, and a controller. The leakage current detection circuit includes a leakage current transformer, a self-excited oscillation circuit, and a sampling resistor. A controller may be connected to one end of the sampling resistor in the leakage current detection circuit.

A circuit topology of the leakage current detection circuit may be the circuit topology mentioned in the foregoing solutions. Details are not described herein again. A filter circuit may be configured to: filter sampled signals at two ends of the sampling resistor to obtain an output signal, and transfer the output signal to a calculation circuit. When there is no leakage current on a power connection line, a waveform of the sampled signal is symmetrical in a positive half cycle and a negative half cycle in an excitation cycle. For example, in FIG. 5, the voltage waveform at the two ends of the resistor R1 is symmetrical in the positive half cycle and the negative half cycle in the excitation cycle, that is, an area of the waveform in the negative half cycle is the same as an area of the waveform in the positive half cycle, so that an integral value of a voltage value of a voltage at the two ends of the resistor R1 in a single cycle is 0. In this way, in an ideal case, a voltage amplitude at the two ends of the resistor R1 is 0.

When there is a leakage current on a power connection line, a waveform of the sampled signal is asymmetrical in positive and negative directions in an excitation cycle. For example, in FIG. 5, the voltage waveform at the two ends of the resistor R1 is asymmetrical in positive and negative directions in the excitation cycle, that is, an area of the waveform in a negative half cycle is different from an area of the waveform in a positive half cycle, so that an integral value of a voltage value of the voltage at the two ends of the resistor R1 in a single cycle is not 0. In this way, in an ideal case, a voltage amplitude at the two ends of the resistor R1 is no longer 0. In other words, compared with a case in which there is no leakage current, a voltage amplitude difference occurs when there is a leakage current.

It should be noted that there may be a mapping relationship between the voltage amplitude difference and a magnitude of the leakage current, and the mapping relationship may be obtained in advance through experimental measurement. In addition, a larger voltage amplitude difference indicates a larger magnitude of the leakage current; and a smaller voltage amplitude difference indicates a smaller magnitude of the leakage current. In this way, when a voltage amplitude difference is obtained, a magnitude of the leakage current can be determined based on the voltage amplitude difference and the foregoing mapping relationship.

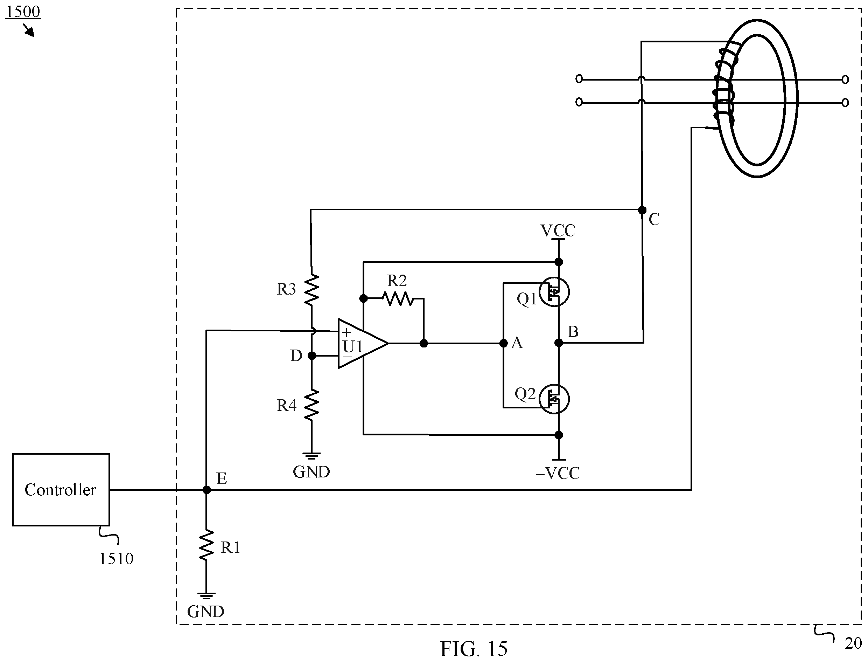

For example, based on the leakage current detection circuit 20 shown in FIG. 2, a circuit topology of the leakage current detection apparatus is shown in FIG. 15. In FIG. 15, a leakage current detection apparatus 1500 includes a positive direct current source VCC, a negative direct current source -VCC, a leakage current detection circuit 20, and a controller 1510. One end of the resistor R1 is separately connected to the non-inverting input end of the comparator U1, the controller 1510, and the first end of the detection winding 2102, and the other end of the resistor R1 is grounded. The controller 1510 may be configured to: when an integral value of a voltage value of a voltage at both ends of the resistor R1 in a single cycle is not 0 (or a voltage amplitude at the two ends of the resistor R1 is not 0), output a signal indicating that there is a leakage current on the power connection line 230. In this way, the leakage current detection apparatus 1500 can detect, based on the voltage at the two ends of the resistor R1, whether there is a leakage current on the power connection line 230.

In another possible implementation, the leakage current detection apparatus may include a filter circuit, and the controller is connected to one end of the sampling resistor via the filter circuit. The filter circuit may be configured to: filter sampled signals at the two ends of the sampling resistor to obtain an output signal, and transfer the output signal to the controller.

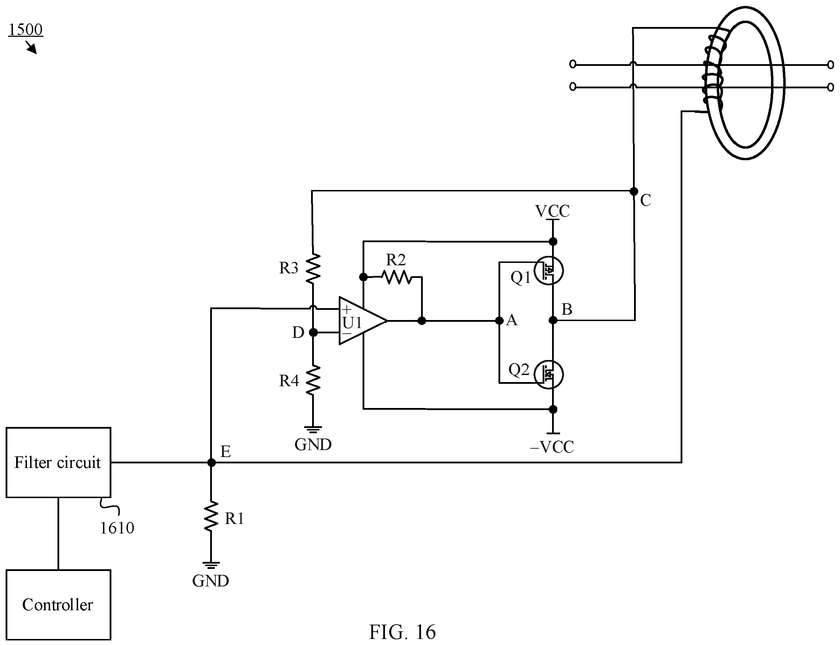

For example, based on FIG. 15, as shown in FIG. 16, in FIG. 16, the leakage current detection apparatus 1500 further includes a filter circuit 1610. One end of the resistor R1 is separately connected to the non-inverting input end of the comparator U1, an input end of the filter circuit 1610, and the first end of the detection winding 2102, and the other end of the resistor R1 is grounded. An output end of the filter circuit 1610 is connected to the controller 1510. The filter circuit 1610 is configured to filter the sampled signals at the two ends of the resistor R1 to obtain an output signal. The controller 1510 is configured to determine, based on whether a voltage amplitude of the output signal is 0, whether there is a leakage current on the power connection line 230. When the voltage amplitude of the output signal is 0, it indicates that there is no leakage current on the power connection line 230. When the voltage amplitude of the output signal is not 0, it indicates that there is a leakage current on the power connection line 230.

### [Solution 8]

In "Solution 8", an inverter in which a leakage current detection apparatus is located is specifically described in this embodiment. During specific implementation, the inverter may include an inverter circuit and the leakage current detection apparatus.

The inverter circuit may be a circuit that converts a direct current signal into an alternating current signal. An input end of the inverter circuit is connected to a photovoltaic string, and an output end of the inverter circuit is connected to a load through a power connection line. The load may include an alternating current grid.

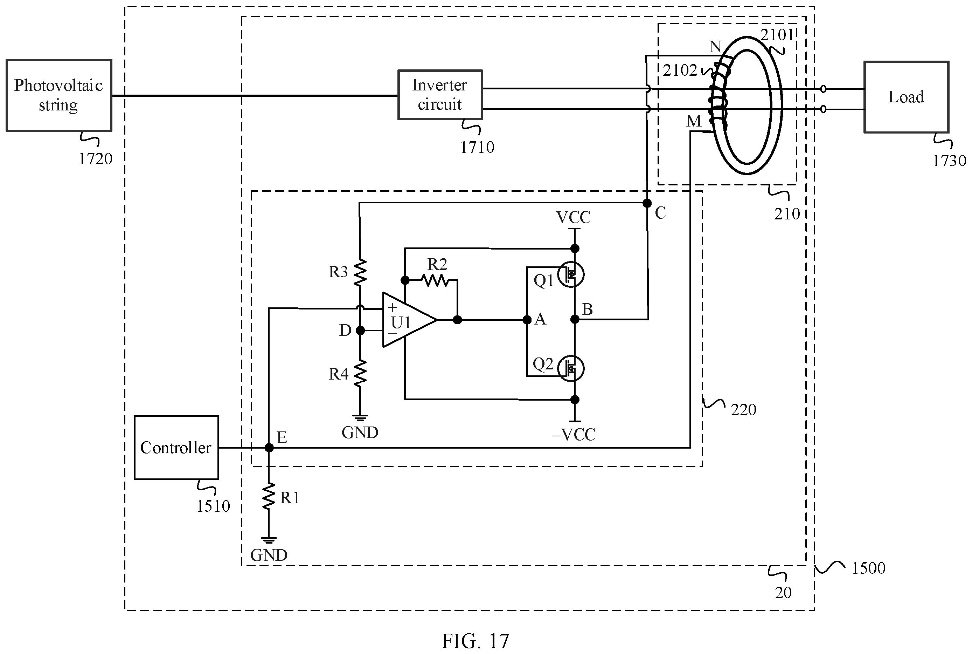

For example, based on the leakage current detection apparatus 1500 shown in FIG. 15, a circuit topology of the inverter is shown in FIG. 17. In FIG. 17, an inverter 1700 includes an inverter circuit 1710 and a leakage current detection apparatus 1500. An input end of the inverter circuit 1710 is connected to a photovoltaic string 1720, and an output end of the inverter circuit 1710 is connected to a load 1730 through a power connection line 230. The inverter circuit 1710 is configured to: convert a received direct current into an alternating current, and output the alternating current to the load 1730. In this way, the leakage current detection apparatus 1500 can perform leakage current protection on the inverter 1700, to improve safety of the inverter 1700.

In another possible implementation, the inverter further includes a switch circuit. The switch circuit is disposed on the power connection line, and the switch circuit is connected to the controller. The controller is further configured to: when a signal indicates that there is a leakage current on the power connection line, input a signal for controlling the switch circuit to be turned off. In this way, because the switch circuit is disposed on the power connection line, when a signal indicates that there is a leakage current on the power connection line, the switch circuit is turned off to avoid impact of the leakage current on a circuit on the power connection line.

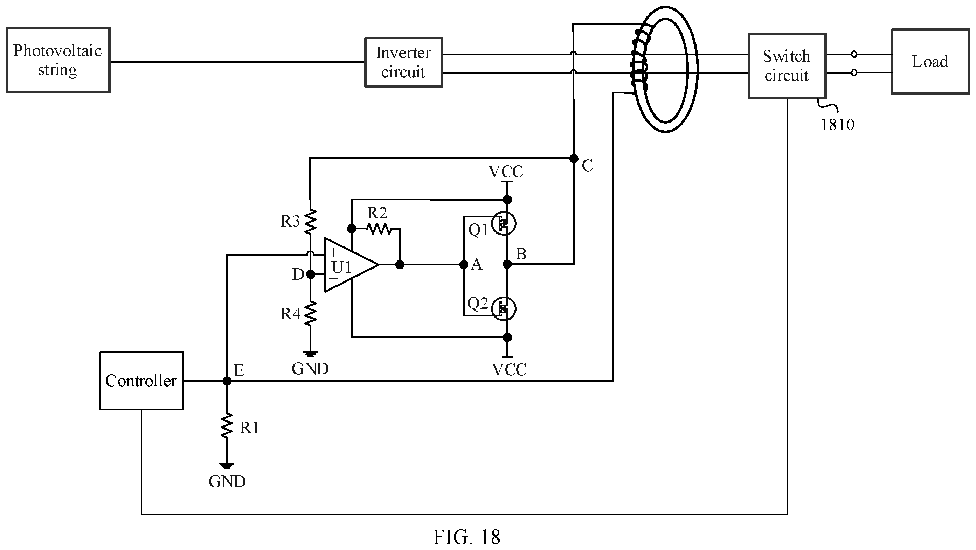

For example, based on FIG. 17, as shown in FIG. 18, the inverter 1700 further includes a switch circuit 1810. The switch circuit 1810 is disposed on the power connection line 230, and is connected to the controller 1510. In the foregoing specific implementations, the objectives, technical solutions, and beneficial effects of this application are further described in detail. It should be understood that the foregoing descriptions are merely specific implementations of this application, but are not intended to limit the protection scope of this application. Any modification, equivalent replacement, improvement, or the like made based on the technical solutions of this application shall fall within the protection scope of this application.

## Claims

1. An inverter, comprising an inverter circuit and a leakage current detection apparatus, wherein
the inverter circuit is configured to: convert a received direct current into an alternating current, and output the alternating current to a load;
the leakage current detection apparatus comprises a positive direct current source, a negative direct current source, a leakage current transformer, a self-excited oscillation circuit, a sampling resistor, and a controller;
the leakage current transformer comprises a magnetic core and a detection winding wound around the magnetic core, and the magnetic core is sleeved on a power connection line between the inverter circuit and the load;
the self-excited oscillation circuit comprises a comparator, a first resistor, a first voltage divider resistor, a second voltage divider resistor, a first switching transistor, and a second switching transistor;
a first power supply end of the comparator is separately connected to the positive direct current source and one end of the first resistor, the other end of the first resistor is connected to an output end of the comparator, and a second power supply end of the comparator is connected to the negative direct current source;
a non-inverting input end of the comparator is connected to a first end of the detection winding;
an inverting input end of the comparator is separately connected to one end of the first voltage divider resistor and one end of the second voltage divider resistor, the other end of the first voltage divider resistor is connected to a second end of the detection winding, and the other end of the second voltage divider resistor is grounded;
the output end of the comparator is separately connected to a drive end of the first switching transistor and a drive end of the second switching transistor;
an input end of the first switching transistor is connected to the positive direct current source, and an output end of the second switching transistor is connected to the negative direct current source;
an output end of the first switching transistor is separately connected to an input end of the second switching transistor and the second end of the detection winding;
one end of the sampling resistor is connected to the non-inverting input end of the comparator, and the other end of the sampling resistor is grounded; and
the controller is configured to: when an integral value of a voltage value of a voltage at two ends of the sampling resistor in a single cycle is not 0, output a signal indicating that there is a leakage current on the power connection line.

2. The inverter according to claim 1, wherein if an input voltage of the non-inverting input end of the comparator is higher than an input voltage of the inverting input end of the comparator, a signal output by the comparator is at a high level; or
if an input voltage of the non-inverting input end of the comparator is lower than an input voltage of the inverting input end of the comparator, a signal output by the comparator is at a low level; and
if the signal output by the comparator is at a high level, the first switching transistor is in an off state and the second switching transistor is in an on state; or
if the signal output by the comparator is at a low level, the first switching transistor is in an on state and the second switching transistor is in an off state.

3. The inverter according to claim 1, wherein the self-excited oscillation circuit further comprises a first current-limiting resistor and a second current-limiting resistor;
the input end of the first switching transistor is connected to the positive direct current source via the first current-limiting resistor; and
the output end of the second switching transistor is connected to the negative direct current source via the second current-limiting resistor.

4. The inverter according to claim 1, wherein the self-excited oscillation circuit further comprises a third current-limiting resistor and a fourth current-limiting resistor;
the output end of the first switching transistor is connected to one end of the third current-limiting resistor, and the input end of the second switching transistor is connected to one end of the fourth current-limiting resistor; and
the other end of the third current-limiting resistor is separately connected to the other end of the fourth current-limiting resistor and the second end of the detection winding.

5. The inverter according to claim 1, wherein the self-excited oscillation circuit further comprises a first diode and a second diode;
a positive end of the first diode is separately connected to a negative end of the second diode and the second end of the detection winding, and a negative end of the first diode is connected to the positive direct current source; and
a positive end of the second diode is connected to the negative direct current source.

6. The inverter according to claim 1, wherein the self-excited oscillation circuit further comprises a second resistor; and
the output end of the comparator is connected to one end of the second resistor, and the other end of the second resistor is separately connected to the drive end of the first switching transistor and the drive end of the second switching transistor.

7. The inverter according to claim 1, wherein the self-excited oscillation circuit further comprises a third resistor; and
the non-inverting input end of the comparator is connected to one end of the third resistor, and the other end of the third resistor is separately connected to the first end of the detection winding and the end of the sampling resistor.

8. The inverter according to any one of claims 1 to 7, wherein the drive end of the first switching transistor is a gate of a P-channel metal-oxide-semiconductor PMOS transistor, the input end of the first switching transistor is a source of the PMOS transistor, and the output end of the first switching transistor is a drain of the PMOS transistor; and
the drive end of the second switching transistor is a gate of an N-channel metal-oxide-semiconductor NMOS transistor, the input end of the second switching transistor is a drain of the NMOS transistor, and the output end of the second switching transistor is a source of the NMOS transistor.

9. The inverter according to any one of claims 1 to 8, wherein the inverter further comprises a switch circuit, and the switch circuit is disposed on the power connection line; and
the controller is further configured to: when a signal indicates that there is a leakage current on the power connection line, input a signal for controlling the switch circuit to be turned off.

10. A leakage current detection apparatus, comprising a positive direct current source, a negative direct current source, a leakage current transformer, a self-excited oscillation circuit, a sampling resistor, and a controller, wherein
the leakage current transformer comprises a magnetic core and a detection winding wound around the magnetic core, and the magnetic core is sleeved on a power connection line;
the self-excited oscillation circuit comprises a comparator, a first resistor, a first voltage divider resistor, a second voltage divider resistor, a first switching transistor, and a second switching transistor;
a first power supply end of the comparator is separately connected to the positive direct current source and one end of the first resistor, the other end of the first resistor is connected to an output end of the comparator, and a second power supply end of the comparator is connected to the negative direct current source;
a non-inverting input end of the comparator is connected to a first end of the detection winding;
an inverting input end of the comparator is separately connected to one end of the first voltage divider resistor and one end of the second voltage divider resistor, the other end of the first voltage divider resistor is connected to a second end of the detection winding, and the other end of the second voltage divider resistor is grounded;
the output end of the comparator is separately connected to a drive end of the first switching transistor and a drive end of the second switching transistor;
an input end of the first switching transistor is connected to the positive direct current source, and an output end of the second switching transistor is connected to the negative direct current source;
an output end of the first switching transistor is separately connected to an input end of the second switching transistor and the second end of the detection winding;
one end of the sampling resistor is connected to the non-inverting input end of the comparator, and the other end of the sampling resistor is grounded; and
the controller is configured to: when an integral value of a voltage value of a voltage at two ends of the sampling resistor in a single cycle is not 0, output a signal indicating that there is a leakage current on the power connection line.
